# EUROPEAN PATENT APPLICATION

(11) **EP 2 196 264 A1**
(43) Date of publication of application: **16.06.2010**
(21) Application number: 09252769.6
(22) Date of filing: 11.12.2009
(51) Int. Cl.: B01L 3/00

(54) **Channel for capillary flow, biosensor device and method for forming an object having a channel for capillary flow**

(30) Priority: 12.12.2008 GB 0822725
(71) Applicant: F.HOFFMANN-LA ROCHE AG, 4070 Basel (CH)
(72) Inventor: Hyland, Mark , Roche Diagnostics Operations Inc., Indianapolis, IN 46250-0416 (US); Hallynck, Sylvain, Roche Diagnostics Operations Inc., Indianapolis, IN 46250-0416 (US); Schoen, Chris , Roche Diagnostics Operations Inc., Indianapolis, IN 46250-0416 (US); Wagener, Michael, Roche Diagnostics Operations Inc., Indianapolis, IN 46250-0416 (US)
(74) Representative: Hopkin, Tobias J.B.

(57) **Abstract**

A channel (10) is provided for conveying fluid by capillary action between a first end of the channel and a second end of the channel, in which the channel is fully enclosed within an object and the cross-section of the channel has a concave shape, encouraging capillary flow.

## Description

The present invention relates to a channel that is configured to provide capillary flow. In particular, the present invention relates to a channel that is configured to convey fluid by capillary action between a first end of the channel and a second end of the channel. The present invention also relates to a biosensor device incorporating such a channel and to a method of forming an object that includes such a channel.

In a biosensor device, for example, an arrangement may be provided to convey a fluid to be sampled from a collection area to a testing area in which the sample may be analysed. It has previously been known to provide a channel or groove that conveys fluid from the collection area to the testing area by capillary action.

However, a problem of known arrangements of this type is that the fluid flow provided may not be consistent and/or may not have a sufficiently high volumetric flow rate. This may result in problems in the testing section of a biosensor device. In particular, if the testing section involves chemical analysis that requires re-suspension of chemicals within the testing section, inadequate or inconsistent fluid flow may result in the testing results being significantly affected. For example, instead of complete re-suspension of the chemicals, only a gel may form, resulting in improper operation of the testing section.

It is therefore desirable to provide an arrangement that may be used, for example, within a biosensor device in order to provide an improved flow of fluid of a sample to be tested from a collection area to a testing area.

According to the present invention there is provided a channel configured to convey fluid by capillary action between a first end of the channel and a second end of the channel;
wherein the channel is fully enclosed within an object; and
the cross-section of the channel, perpendicular to the direction in which fluid is conveyed by the channel, has a concave shape.

It will be appreciated that a concave shape is a shape that includes at least one interior angle that is greater than 180°. Accordingly, a channel having such a cross-section may include a plurality of different portions. In particular, the channel may include a main channel portion and at least one subsidiary channel portion, in which the smallest dimension of the main channel portion is larger than the smallest dimension of the at least one subsidiary channel portion.

The extent of capillary action may be determined by a variety of factors. However, the size of a channel or channel portion is an important determining factor. In particular, minimising the size of the smallest dimension of a channel may increase the capillary action. Accordingly, providing at least one subsidiary channel portion having a relatively small minimum dimension encourages capillary flow across the entire cross-section of the channel. This may be particularly advantageous in the case that a surface of the channel, for example adjacent to the at least one subsidiary channel portion is relatively hydrophobic.

In a particular arrangement, the channel may have two subsidiary channel portions, which in conjunction with the main channel portion are arranged such that the cross-section of the channel has three lobes. Such an arrangement may be particularly beneficial if one side of the channel is formed from a relatively hydrophobic surface. In that case, the two subsidiary channel portions may be arranged on either side of the main channel portion and adjacent to the relatively hydrophobic surface. Such an arrangement may encourage capillary flow within the entire cross-section of the channel despite the relatively hydrophobic surface.

In an arrangement, the smallest dimension of the cross-section of the main channel portion is between approximately twice as large and ten times as large as the smallest dimension of the cross-section of the at least one subsidiary channel portion. In an arrangement, the at least one subsidiary channel portion may be configured to be between approximately 10µm and approximately 200µm across, optionally between approximately 15µm and approximately 50µm across, and the main channel may be configured to be between approximately 50µm and approximately 200µm across, optionally between approximately 100µm and approximately 200µm across. Such arrangements may be particularly beneficial for ensuring consistency of fluid flow through the channel and maximum volumetric flow rate.

The object within which the channel is formed may comprise first and second layers of material joined together by a layer of adhesive material. In that case, the channel may conveniently be formed with the desired shape by forming the main channel portion in the first layer of material and at least a part of the at least one subsidiary channel portion in the layer of adhesive material.

One side of the cross-section of the channel may be formed by a surface of the second layer of material. Accordingly, the completed channel may be formed by combining together the first and second layers of material with the layer of adhesive material.

In particular, the main channel portion may be formed by the provision of a groove within a first surface of the first layer of material and the subsidiary channel portions may be formed by the provision of a slot through the layer of adhesive material that is wider than the groove in a direction that is perpendicular to the length of the channel but parallel to a line that lies within the first surface of the first layer of material. Accordingly, when the first and second layers of material are joined together by the layer of adhesive material such that the slot is aligned with the groove, the at least one subsidiary channel portion is formed by the extension of the slot beyond the edges of the groove. It will be appreciated that such an arrangement provides a simple arrangement for forming the desired cross-section of the channel.

In one arrangement, the desired relationship between the sizes of the at least one subsidiary channel portion and the main channel portion is provided by selecting the thickness of the layer of adhesive material, in a direction perpendicular to the first surface of the first layer of material, such that it is between approximately a half and approximately a tenth of the width of the groove in the first surface of the first layer of material in a direction that is perpendicular to the length of the groove and parallel to a line lying within the first surface of the first layer of material.

In an alternative arrangement, the first and second layers of material may be mechanically secured to each other, for example by clamps. In such an arrangement, at least a part of the main channel portion may be formed in the surface of the first layer of material that abuts the second layer of material. For example, the main channel portion may be formed by means of a groove within the surface of the first layer of material. The at least one subsidiary channel portion may be formed by means of a second groove within the surface of the second layer of material that abuts the first layer of material, that is wider than the main channel portion.

Alternatively or additionally, at least a part of the subsidiary channel portion may be formed in the first layer of material. In that case, a stepped groove may be provided in the surface of the first layer of material that abuts the second layer of material. The stepped groove may include a first part that corresponds to the main channel portion and a wider but shallower second portion, extending beyond the edges of the first part of the stepped groove in order to provide at least a part of the at least one subsidiary channel portion.

In order to maximise the capillary action of the fluid flow through the channel, at least one surface of the channel may be coated with a hydrophilic coating. In particular, in an object formed from first and second layers that are either joined together by a layer of adhesive material or are mechanically secured together, the surfaces of the channel that are formed from the first layer of material may be coated with a hydrophilic coating. In addition, the surfaces of the layer of adhesive material, where used, that comprise a part of the channel, may be coated with a layer of hydrophilic material.

The present invention may, in particular, provide a biosensor device that comprises:
a sample collection area, configured to receive a sample to be analysed by the biosensor device;
a sensor configured to analyse at least a portion of the sample; and
a channel such as that discussed above, configured to convey fluid from the sample collection area to the sensor.

Such a biosensor device may in particular include a channel having a main channel portion and at least one subsidiary channel portion that adjoins the main channel portion and is configured such that the smallest dimension of the cross-section of the main channel portion is larger than the smallest dimension of the cross-section of the at least one subsidiary channel portion. In such an arrangement the sensor may include a test chamber connected for fluid flow to the channel such that the test chamber adjoins a side of the channel that includes said at least one subsidiary channel portion.

According to the present invention there is also provided a method of forming an object that has a channel, fully enclosed within the object, configured to convey fluid by capillary action between a first end of the channel and a second end of the channel;
wherein the cross-section of the channel, perpendicular to the direction in which the fluid is conveyed by the channel, has a concave shape;
the method comprising joining together a first and a second layer of material;
wherein a groove is formed in a first surface of the first layer of material;
the first and second layers of material are joined such that the second layer of material is joined to the first surface of the first layer of material; and
the groove in the first surface of the first layer of material forms at least a part of the channel.

The method of the present invention provides a straightforward means of providing an object having a channel with the desired shape in cross-section, in order to provide a channel with improved fluid flow.

The first and second layers of material may be joined together by a layer of adhesive material. In that case, a slot may be formed within the layer of adhesive material and, when the first and second layers of material are joined together by means of the layer of adhesive material, the slot in the layer of adhesive material may be aligned with the groove in the first surface of the first layer of material.

In a particular arrangement, the slot in the layer of adhesive material may be formed to be wider than the groove formed in the first surface of the first layer of material. In particular, therefore, when the layer of adhesive material is used to join the first and second layers of material, the slot in the layer of adhesive material extends beyond the edges of the groove in the first surface of the first layer of material. Accordingly, the portions of the slot in the layer of the adhesive material that extend beyond the edges of the groove in the first layer of material form the subsidiary channel portions and are adjacent to the surface of the second layer of material that adheres to the layer of adhesive material.

The layer of adhesive material may be formed with a release layer on one or both surfaces of its primary faces, namely the faces that are to be adhered to the first and second layers of material. In particular, the layer of adhesive material may include a release layer on the surface of the layer of adhesive material that is to adhere to the first surface of the second layer of material. In that case, after the layer of adhesive material has been adhered to the first layer of material, a hydrophilic coating may be applied to the object. In such an arrangement, the hydrophilic coating will be applied to the edges of the slot through the layer of adhesive material and to the surfaces of the first layer of material that are exposed by the slot through the layer of adhesive material. In particular, there may be the surfaces of the groove in the first surface of the first layer of material. However, the release layer may function as a mask, preventing the application of the hydrophilic coating to the object from affecting the adhesion of the layer of adhesive material to the first surface of the second layer of material once the release layer is subsequently removed.

The invention will now be described by way of non-limiting examples with reference to the accompanying drawings, in which:
Figure 1 depicts an expanded view of the biosensor device that may include a channel according to the present invention;
Figure 2 depicts in cross-section a channel according to the present invention;
Figures 3a and 3b depict possible arrangements of a channel according to the present invention within an object such as a biosensor device; and
Figures 4 to 8 depict further possible arrangements of a channel according to the present invention within an object such as a biosensor device.

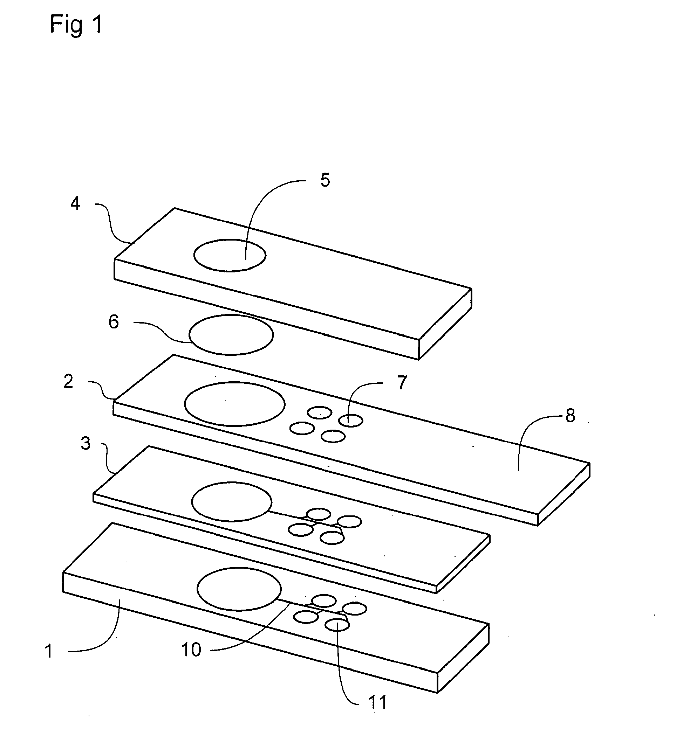

Figure 1 depicts an expanded view of an arrangement of a biosensor device that may be used with the present invention.

As shown, the biosensor device may include a fluid handling layer 1, an analysis layer 2, a layer of adhesive material 3 and a cover layer 4. The cover layer 4 may include an opening 5 that, in conjunction with the fluid handling layer 1, provides a collection area for receiving a fluid sample. A membrane 6 may be provided to filter the fluid sample.

The analysis layer 2 may include one or more sample analysis, or testing sections 7, at which the fluid is analysed. It will be appreciated that, depending on the analysis to be performed, any number of testing sections 7 may be provided. As shown, the analysis layer 2 may be provided with an electrode region 8, which may be used to output the results of the analysis. For example, the electrode section 8 may be inserted into a reading device that is used to read the results of the sample analysis.

The analysis layer 2 may be secured to the fluid handling layer 1 by means of the layer of adhesive material 3. It should be appreciated, however, that alternatively or additionally, the analysis layer 2 may be fixed to the fluid handling layer 1 by means of a mechanical fastening, such as some form of clamp. It should also be appreciated that, although in the arrangement depicted in Figure 1 and discussed above the biosensor device is formed from a plurality of layers that are secured together, this need not be the case. In particular, any of the components discussed above may be combined together within a single component.

In any case, a channel 10 is provided to convey fluid from the collecting area to the testing section 7. In the arrangement depicted in Figure 1 and discussed above, the channel 10 may at least in part be provided by the fluid handling layer 1. Fluid distribution section 11 may also be provided to distribute the fluid that is conveyed from one end of the channel 10 to the other to each of the testing sections 7.

In such an arrangement as described above, it has previously been considered to provide the channel 10 in the form of a groove, for example having a substantially rectangular cross-section, within the surface of the fluid handling layer 1 that is connected to the analysis layer 2. However, in such an arrangement, when the biosensor device is assembled, one side of the channel may be formed by the layer of adhesive material 3 or by the surface of the analysis layer 2 that is joined to the fluid handling layer 1. These surfaces may be relatively hydrophobic. Consequently, the fluid may not wet on this surface, with the result that the fluid may only flow along the surface of the channel that is opposite the relatively hydrophobic surface or along the corners opposite the relatively hydrophobic surface, depending upon the shape of the groove. Consequently, the entire cross-section of the groove is not filled with fluid. This may reduce the volumetric flow rate from that which may otherwise be attainable and may also result in an inconsistent flow rate. As explained above, this is undesirable.

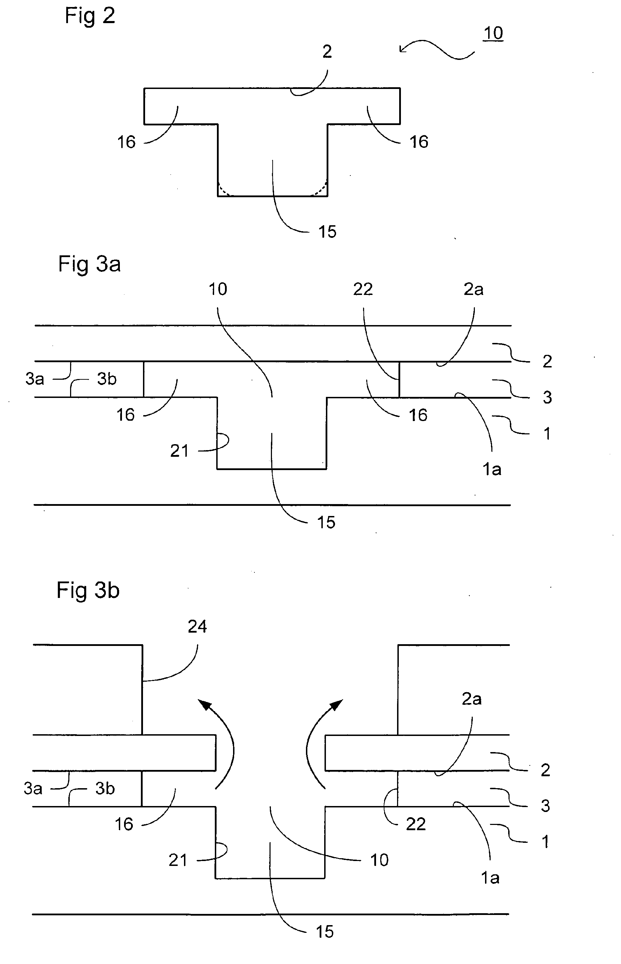

The difficulties discussed above have been reduced by means of the use of a channel according to the present invention. In particular, the present invention provides a channel for capillary flow that has a cross-section having a shape that is specifically provided to encourage capillary flow. For example, as shown in Figure 2, the channel 10 may include a main channel portion 15 and one or more subsidiary channel portions 16 that are smaller than the main channel portion 15. In particular, the subsidiary channel portions 16 may be configured such that the smallest dimension across the cross-section of the subsidiary channel portion is smaller than the smallest dimension of the cross-section of the main channel portion. Such an arrangement assists in the provision of capillary flow within the channel 10 because the capillary action within the relatively small subsidiary channel portions 16 is greater than that within the relatively large main channel portion 15.

As shown in Figure 2, in a particular arrangement of the channel 10, two subsidiary channel portions 16 may be provided such that the overall cross-section of the channel 10 is one having three lobes, namely protrusions. Two such lobes may correspond to the subsidiary channel portions 16 and one lobe may correspond to the main channel portion 15.

For the convenience of the formation of the channel 10, each of the channel portions 15, 16 may be substantially rectangular in shape. However, it will be appreciated that this is not essential. In particular, depending on the method of formation of the main channel portion 15, the corners of the main channel portion, in particular, may be rounded, as shown by the broken lines in Figure 2.

As shown in Figure 2, the channel 10 may be configured such that the subsidiary channel portions 16, in which the capillary action will be greatest, are adjacent to a surface of the channel, such as a surface of the analysis layer 2, for example, that is relatively hydrophobic. Accordingly, the smaller size of the subsidiary channel portions 16 may overcome the relatively hydrophobic nature of the surface adjacent the subsidiary channel portions 16. Consequently, fluid may be drawn into the subsidiary channel portion notwithstanding the relatively hydrophobic surface, and retained within the subsidiary channel portions 16. Accordingly, the fluid flow within the channel 10 may utilise the entire cross-section of the channel 10. This may improve both the consistency of the fluid flow within the channel 10 and/or the volumetric flow rate.

It will be appreciated that, although Figure 2 depicts a particularly advantageous arrangement of the channel 10 according to the present invention, other arrangements are also possible. In particular, alternative arrangements may be provided having at least one subsidiary channel portion adjacent to a main channel portion and configured such that the minimum dimension of the main channel portion is larger than the minimum dimension of the subsidiary channel portion. As explained above, such an arrangement may ensure enhanced capillary action within the subsidiary channel portion as compared with the main channel portion alone. Accordingly, such an arrangement may be used to overcome the problems that may be caused by a relatively hydrophobic surface within the channel. In general, it will be appreciated that such an arrangement may be provided by the provision of a channel having a cross-section that has a concave shape, namely a shape having at least one internal angle that is greater than 180°. It will be appreciated that such a concave shape may be a concave polygon. However, as explained above, at least one edge or corner of the shape may also be curved.

In analysis of a channel 10 having a cross-section of the general shape depicted in Figure 2, and having a relatively hydrophobic surface adjacent the subsidiary channel portions 16 and relatively hydrophilic surfaces elsewhere, it has been found that improved volumetric flow rate may be provided where the minimum dimension of the main channel portion 15 is significantly larger than the size of the minimum dimension of the subsidiary channel portions 16. For example, if the minimum dimension of the main channel portion 15 is between approximately two and ten times the minimum dimension of the subsidiary channel portions 16, improved volumetric flow rate may be provided.

In a particular example, the height of the subsidiary channel portion may be configured to be between approximately 10µm and approximately 200µm, optionally between approximately 15µm and approximately 50µm, and the height of the main channel may be configured to be between approximately 50µm and approximately 200µm, optionally between approximately 100µm and approximately 200µm.

Figure 3a schematically depicts the arrangement of a channel 10 according to the present invention within a biosensor device such as that depicted in Figure 1. Accordingly, the provision of the channel 10 is described with reference to the arrangement of a fluid handling layer 1, an analysis layer 2 and a layer of adhesive material 3. However, it should be appreciated that the channel 10 may be provided in any other object in which it is required. It should therefore be understood that, in that case, other layers may be provided in place of those referred to in this description.

As shown, the channel 10 is formed from a groove 21 that is formed in a first surface 1a of the fluid handling layer 1 and a slot 22 that is formed through the layer of adhesive material 3 that joins the first surface 1a of the fluid handling layer 1 to a first surface 2a of the analysis layer 2.

As shown, the groove 2 1 in the fluid handling layer 1 is aligned with the slot 22 formed through the layer of adhesive material 3. Furthermore, the slot 22 is wider than the groove 21 in a direction that is perpendicular to the length of the channel 10 and to a line lying within a plane parallel to the first surface 1 a of the fluid handling layer 1. Consequently, as shown in Figure 3a, the groove 21 within the first surface 1a of the fluid handling layer 1 forms a main channel portion 15 corresponding to that depicted in Figure 2. Likewise, the portion of the slot 22 through the layer of adhesive material 3 that extends beyond the groove 21 in the fluid handling layer forms subsidiary channel portions 16 that correspond to those depicted in Figure 2.

Accordingly, by the formation of a simple groove shape in one layer of material and a simple slot shape in another layer, it is possible to form easily a channel 10 having a cross-section including the main channel portion and the at least one subsidiary channel portion according to the present invention.

In particular, the groove 21 may be formed in the first surface 1a of the fluid handling layer 1 before assembly of the biosensor device. For example, the groove 21 may be formed integrally within the fluid handling layer, for example as a moulded part of the fluid handling layer. Alternatively, the groove 21 may be formed by machining, for example laser beam machining, after the initial formation of the fluid handling layer 1.

Similarly, the slot 22 in the layer of adhesive material 3 may be formed integrally with the formation of the layer of adhesive material 3 or may be formed subsequently by machining, for example by laser beam machining.

The layer of adhesive material 3 may be provided with a release layer on one or both surfaces 3a, 3b of the layer of adhesive material. In this case, if the slot 22 is formed after the initial formation of the layer of adhesive material 3, the slot 22 may be machined with the release layer(s) in place. In order to assemble the device depicted in Figure 3a, the layer of adhesive material may be applied to the first surface 1a of the fluid handling layer 1 and the analysis layer 2 applied to the other side of the layer of adhesive material 3. It will be appreciated that, if release layers are provided, these will be removed from each surface 3a, 3b of the layer of adhesive material before the layer of adhesive material 3 is applied to the surfaces 2a, 1a of the analysis layer 2 and the fluid handling layer 1, respectively.

In a particular arrangement, the fluid flow within the channel 10 may be further improved by the provision of a hydrophilic treatment to at least one surface of the channel 10. For example, a hydrophilic coating such as silicon based or a surfactant, may be applied to the surface. Such a coating may be applied by a spray or dip coating method or other known methods. Additionally a hydrophilic coating may be applied by plasma polymerisation. Furthermore, the hydrophilic treatment may alternatively or additionally involve a physical modification of the surface, for example plasma treatment or etching.

In particular, a hydrophilic treatment may be applied after the layer of adhesive material 3 has been applied to the first surface 1a of the fluid handling layer 1. Accordingly, the hydrophilic treatment may be applied to substantially all of the surface of the groove 21, the portion of the first surface 1a of the fluid handling layer 1 that is exposed by the slot 22 through the layer of adhesive material 3 and the edges of the slot 22 itself. Accordingly, the hydrophilic treatment may be applied to all of the surfaces of the channel 10 apart from the first surface 2a of the analysis layer 2.

The hydrophilic treatment may be applied after the layer of adhesive material 3 has been applied to the first surface 1a of the fluid handling layer. Accordingly, the hydrophilic treatment may not affect the bonding of the layer of adhesive material 3 to the fluid handling layer 1.

Furthermore, if the layer of adhesive material 3 is provided with a release layer on the surface 3a of the layer of adhesive material 3 that is to adhere to the first surface 2a of the analysis layer 2, the release layer may be retained on the layer of adhesive material 3 during the process to apply the hydrophilic treatment. Accordingly, the release layer may function as a mask, preventing the application of the hydrophilic treatment from affecting the bonding of the layer of adhesive material 3 to the first surface 2a of the analysis layer 2 once the release layer is removed.

Although the provision of a hydrophilic treatment such as that discussed above may assist in the formation of a channel 10 with desirable properties for conveying fluid by capillary action, it will be appreciated that this may not be essential. In any case, it should be appreciated that the groove 21 may be provided with mini-channels, such as scratches, or some other form of surface texture in order to encourage the fluid within the main channel portion 15 to rise up into the subsidiary channel portion 16.

In addition to improving the flow of fluid through the channel, as discussed above, a channel configured according to the present invention may provide other benefits. For example, a channel may be arranged to provide fluid to a test chamber within a device such as a biosensor device. Such a test chamber may, for example form part of a testing section. In that case, with previously known channels, transfer of the fluid from the channel to the test chamber may not be reliable. However, Figure 3b depicts how the channel 10 may assist in filling a test chamber 24 which may, for example be provided towards an end of the channel away from the fluid collection area.

In particular, as shown in Figure 3b, the test chamber 24 may be provided adjacent to and in fluid communication with the channel 10 such that it is on the side of the channel 10 that includes at least one of the subsidiary channel portions 16. Accordingly, as explained above, the provision of the subsidiary channel portions 16 may draw fluid up the sides of the main channel portion. From there, as shown by the arrows in Figure 3b, fluid may more easily be transferred into the test chamber 24 than directly from the main channel portion 15. This is because the subsidiary channel portions 16 may initiate and increase capillary flow.

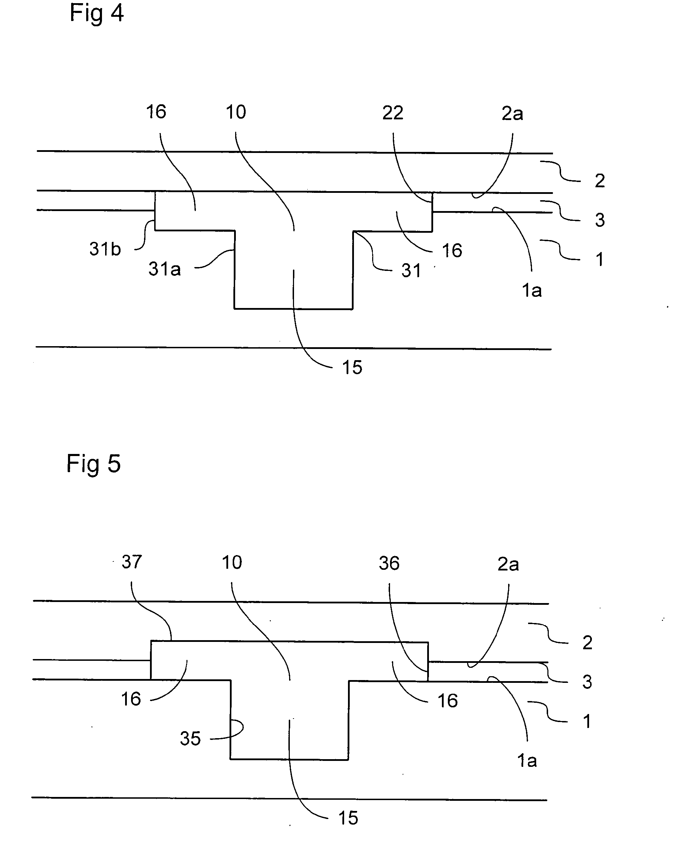

Although the arrangement depicted in Figure 3a and discussed above provides a convenient way to provide the channel 10 of the present invention to an object such as a biosensor device, it should be appreciated that alternative arrangements may be provided. For example, Figure 4 depicts an alternative arrangement for providing the channel 10 of the present invention having a shape corresponding to that depicted in Figure 2 to a biosensor device having a fluid handling layer 1, an analysis layer 2 and a layer of adhesive material 3. The arrangement is similar to that discussed above in relation to Figure 3a and it will be appreciated that the variations discussed above in relation to Figure 3a may also apply to the arrangement depicted in Figure 4. Accordingly, only the differences will be discussed.

In particular, as shown, in the arrangement shown in Figure 4 the layer of adhesive material 3 includes a slot 22 through the layer of adhesive material 3 that is aligned with a groove 31 in the first surface 1a of the fluid handling layer 1. However, in the arrangement depicted in Figure 4, the groove 31 is a stepped groove, having a first section 31a providing the main channel portion 15 of the channel 10 and a second portion 31 b that is substantially as wide as the slot 22 through the layer of adhesive material 3. Accordingly, the subsidiary channel portions 16 are provided by the combination of the second part 31 b of the groove 31 in the fluid handling layer 1 and the portions of the slot 22 that extend beyond the first part 31a of the groove 31. It will be appreciated that such an arrangement may require additional processing steps to manufacture in comparison with the arrangement depicted in Figure 3a. However, the arrangement depicted in Figure 4 may facilitate control of the formation of the subsidiary channel portions 16, for example if accurate control of the formation of the slot 22 through the layer of adhesive material 3 is difficult.

The channel 10 of the present invention may also be provided by the provision of a groove 31 within the first surface 1a of the fluid handling layer 1 in conjunction with a layer of adhesive material 3 that does not include a slot. Accordingly, the channel 10, including the main channel portion 15 and the subsidiary channel portions 16, is formed entirely by the groove 31. In this case, it will be appreciated that the upper surface of the channel 10 may be formed by a surface of the layer of adhesive material 3. It will also be appreciated that if a hydrophilic coating is to be provided in such an arrangement, it may be provided before the layer of adhesive material 3 is applied to the first surface 1a of the fluid handling layer.

Figure 5 depicts a further arrangement for providing a channel 10 according to the present invention within a biosensor device having a fluid handling layer 1, an analysis layer 2 and a layer of adhesive material 3. As before, previously discussed variations may also apply to this arrangement.

In the arrangement shown in Figure 5, a first groove 35 is formed within the first surface 1a of the fluid handling layer 1 in a manner corresponding to that discussed above in relation to Figure 3a. Likewise, a slot 36 is formed through the layer of adhesive material 3 in a manner corresponding to that as discussed above in relation to Figure 3a. However, in addition, a groove 37 is also formed within the first surface 2a of the analysis layer 2. Such a groove 37 may be integrally formed with the analysis layer 2 when the analysis layer 2 is formed. Alternatively, it may be formed by subsequent machining, such as by laser beam machining.

As depicted in Figure 5, the groove 37 in the analysis layer may be aligned with the slot 36 through the layer of adhesive material 3, providing the subsidiary channel portions 16. It will be appreciated that, as with the arrangement depicted in Figure 4 and discussed above, the arrangement depicted in Figure 5 may require additional processing steps in comparison to the arrangement depicted in Figure 3a and discussed above. However, the provision of the groove 37 within the analysis layer 2 may enable more accurate control of the formation of the channel 10.

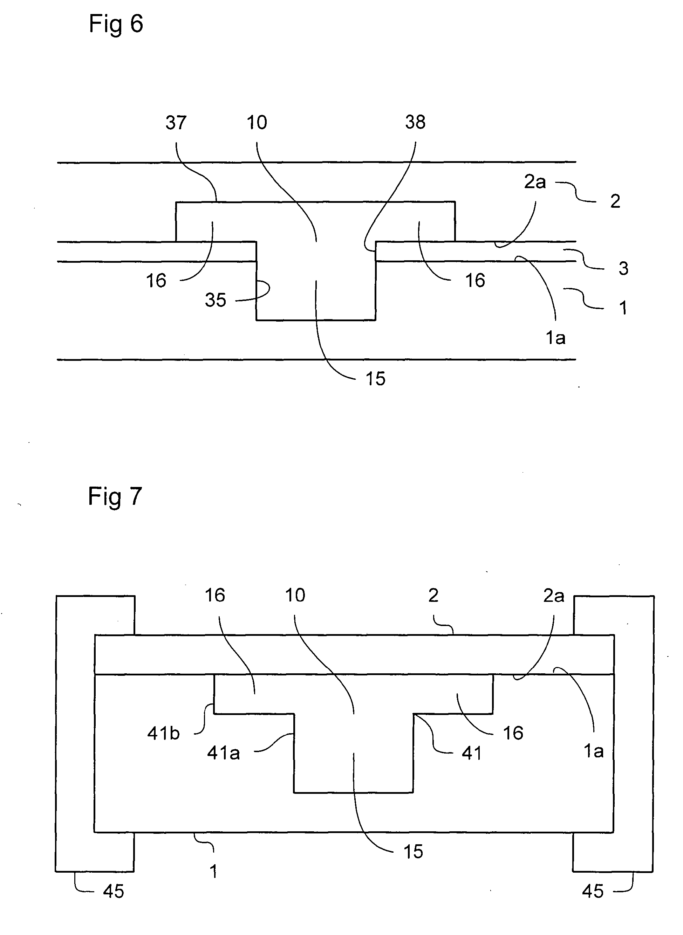

Figure 6 depicts a further arrangement for providing a channel 10 according to the present invention within a biosensor device having a fluid handling layer 1, an analysis layer 2 and a layer of adhesive 3. This arrangement is largely similar to that depicted in Figure 5, having a groove 35 in the first surface 1a of the fluid handling layer 1, a groove 37 in the first surface 2a of the analysis layer 2 and a slot 38 through the layer of adhesive 3. Accordingly, previously discussed variations may also apply to this arrangement.

However, in the arrangement of Figure 6, the slot 38 through the layer of adhesive 3 is configured to be as wide as the groove 35 in the first surface 1a of the fluid handling layer 1. Accordingly, in the arrangement depicted in Figure 6, the main channel portion is provided by the combination of the groove 35 in the first surface 1a of the fluid handling layer 1 and the slot 38 through the layer of adhesive material. The subsidiary channel portions 16 are provided by the groove 37 in the first surface 2a of the analysis layer 2.

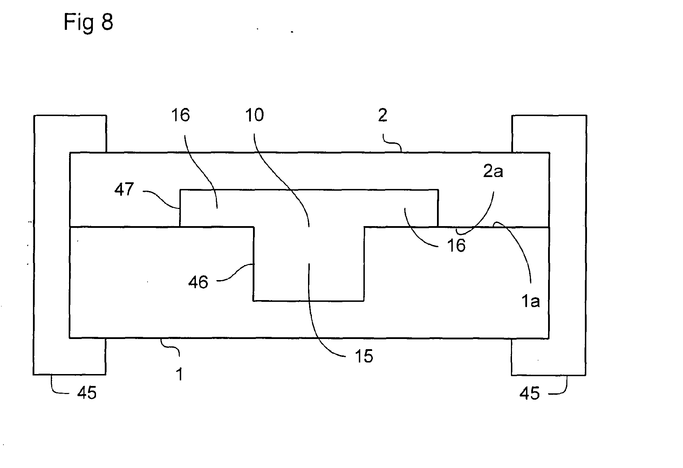

As explained above, a biosensor device according to the present invention may be formed from a fluid handling layer 1 and an analysis layer 2 that are secured together by a mechanical fastening rather than a layer of adhesive material. In such an arrangement, a channel 10 according to the present invention may be provided by an arrangement such as that depicted in Figure 7 and/or an arrangement such as that depicted in Figure 8. It should be noted that, although not depicted in Figures 7 and 8, a gasket may be provided between the fluid handling layer 1 and the analysis layer 2 in order, for example, to prevent fluid leakage.

As depicted in Figure 7, the channel 10 according to the present invention may be provided by the formation of a stepped groove 41 in the first surface 1a of the fluid handling layer 1. Accordingly, the stepped groove 41 may include a first portion 41a that provides the main channel portion 15 of the channel 10, and a second part 41 b of the groove 41 that is wider than the first part 41 a. Therefore, the second part 41 b of the groove 41, in combination with the first surface 2a of the analysis layer 2 may form the subsidiary channel portions 16.

As schematically depicted in Figure 7, clamping sections 45 may be provided to mechanically fasten the fluid handling layer 1 to the analysis layer 2.

As with the arrangements discussed above in relation to Figures 3 to 6, it will be appreciated that a hydrophilic coating may be provided to at least certain surfaces of the channel 10. In particular, a hydrophilic coating may be applied to the surfaces of the channel 10 that are exposed before the analysis layer 2 is connected to the fluid handling layer 1. Likewise, mini-channels, such as scratches, or other surface texturing may be applied to the surfaces of the first part 41a of the groove 41 in the fluid handling layer 1 in order to encourage the flow of the fluid into the subsidiary channel portions 16.

The arrangement depicted in Figure 8 is similar to that depicted in Figure 7. Accordingly, only the differences will be discussed and it will be appreciated that the variations discussed above in relation to Figure 7 apply equally to the arrangement depicted in Figure 8.

As shown in Figure 8, the channel 10 of the arrangement depicted in Figure 8 is formed from a first groove 46 formed in the first surface 1a of the fluid handling layer 1 and a second groove 47 formed in the first surface 2a of the analysis layer 2. As shown, the second groove 47 in the analysis layer 2 is wider than the first groove 46 in the fluid handling layer 1. Accordingly, the main channel portion 15 of the channel 10 is formed by the first groove 46 in the fluid handling layer 1 and the subsidiary channel portions 16 are formed by the overlap of the second groove 47 in the analysis layer 2 beyond the first groove 46 in the fluid handling layer 1.

Finally, it will be appreciated that, although the arrangements depicted in Figures 3 to 8 have been discussed in relation to an object formed from a plurality of layers, in particular a biosensor device, the present invention is not limited to such arrangements. In particular, it will be appreciated that a channel 10 having a main channel portion 15 and at least one subsidiary channel portion 16, such as is provided by the present invention may also be incorporated in other objects in order to provide capillary flow through those objects. In particular, by appropriate machining, such as laser beam machining, a channel 10 according to the present invention may be provided through a solid object. Likewise, a channel 10 according to the present invention may be integrally formed within a solid object by appropriate moulding.

## Claims

1. A channel configured to convey fluid by capillary action between a first end of the channel and a second end of the channel;
wherein the channel is fully enclosed within an object; and
the cross-section of the channel, perpendicular to the direction in which fluid is conveyed by the channel, has a concave shape.

2. A channel according to claim 1, wherein the shape of the cross-section of the channel is a concave polygon.

3. A channel according to claim 1 or 2, wherein the channel comprises a main channel portion and at least one subsidiary channel portion that adjoins the main channel portion; and
the at least one subsidiary channel portion is configured such that the smallest dimension of the cross-section of the main channel portion is larger than the smallest dimension of the cross-section of the at least one subsidiary channel portion;
wherein, optionally, the channel has two subsidiary channel portions; and the main channel portion and the two subsidiary channel portions are arranged such that the shape of the cross-section of the channel has three lobes.

4. A channel according to claim 3, wherein the smallest dimension of the cross-section of the main channel portion is between approximately two and approximately ten times as large as the smallest dimension of the cross-section of the at least one subsidiary channel portion.

5. A channel according to claim 3 or 4, wherein the object within which the channel is formed comprises at least first and second layers of material joined together by a layer of adhesive material; and
at least a part of the main channel portion is formed in the first layer of material and at least a part of the at least one subsidiary channel portion is formed in the layer of adhesive material;
wherein, optionally, one side of the cross-section of the channel is formed by a surface of the second layer of material.

6. A channel according to claim 5, wherein a groove is formed in a first surface of the first layer of material;
a slot is formed through the layer of adhesive material;
the second layer of material is adhered to the first surface of the first layer of material by the layer of adhesive material; and
the slot through the layer of adhesive material is aligned with the groove in the first surface of the first layer of material;
wherein, optionally, the width of the slot through the layer of adhesive material is wider than the width of the groove in the first surface of the first layer of material in a direction that is perpendicular to the length of the slot and parallel to a line lying within the first surface of the first layer of material.

7. A channel according to claim 6, wherein the thickness of the layer of adhesive material in a direction perpendicular to the first surface of the first layer of material is between approximately a half and approximately a tenth of the width of the groove in the first surface of the first layer of material in a direction that is perpendicular to the length of the groove and parallel to a line lying within the first surface of the first layer of material.

8. A channel according to claim 3 or 4, wherein the object within which the channel is formed comprises at least first and second layers of material that are mechanically secured to each other; and
at least a part of the main channel portion is formed in a surface of the first layer of material that abuts the second layer of material;
wherein, optionally, at least a part of the at least one subsidiary channel portion is formed in the second layer of material; and
wherein, optionally, at least a part of the at least one subsidiary channel portion is formed in the first layer of material.

9. A channel according to any one of the preceding claims, wherein a hydrophilic coating is applied to at least one of the surfaces of the channel.

10. A biosensor device, comprising:
a sample collection area, configured to receive a sample to be analysed by the biosensor device;
a sensor, configured to analyse at least a portion of the sample; and
a channel according to any one of the preceding claims, configured to convey fluid from the sample collection area to the sensor.

11. A biosensor device according to claim 10, wherein the channel comprises a main channel portion and at least one subsidiary channel portion that adjoins the main channel portion;
the at least one subsidiary channel portion configured such that the smallest dimension of the cross-section of the main channel portion is larger than the smallest dimension of the cross-section of the at least one subsidiary channel portion; and
the sensor comprises a test chamber connected for fluid flow to the channel, such that the test chamber adjoins a side of the channel that includes said at least one subsidiary channel portion.

12. A method of forming an object that has a channel, fully enclosed within the object, configured to convey fluid by capillary action between a first end of the channel and a second end of the channel;
wherein the cross-section of the channel, perpendicular to the direction in which the fluid is conveyed by the channel, has a concave shape;
the method comprising joining together a first and a second layer of material;
wherein a groove is formed in a first surface of the first layer of material;
the first and second layers of material are joined such that the second layer of material is joined to the first surface of the first layer of material; and
the groove in the first surface of the first layer of material forms at least a part of the channel.

13. A method according to claim 12, wherein the method comprises joining together the first and second layers of material using a layer of an adhesive material; and
the method optionally comprises:
preparing a layer of adhesive material to join the first and second layers of material by forming a slot through the layer of adhesive material; and
joining together the first and second layers of material with the layer of adhesive material such that the slot through the layer of adhesive material is aligned with the groove in the first surface of the first layer of material;
wherein, optionally, the width of the slot through the layer of adhesive material is wider than the width of the groove in the first surface of the first layer of material in a direction that is perpendicular to the length of the slot and parallel to a line lying within the first surface of the first layer of material.

14. A method according to claim 13, wherein the layer of adhesive material is formed with a release layer on at least a first surface of the layer of adhesive material; and the method comprises:
adhering a second surface of the layer of adhesive to the first surface of the first layer of material;
removing the release layer from the first surface of the layer of adhesive material; and
adhering the second layer of material to the first surface of the layer adhesive material;
wherein, optionally, before the release layer is removed from the first surface of the layer of adhesive material, a hydrophilic coating is applied to at least one of the sides of the slot in the layer of adhesive material and the sides of the groove in the first layer of material.

15. A method according to claim 12, wherein a groove is formed in a first surface of the second layer of material;
the method comprises mechanically securing the first layer of material to the second layer of material such that the first surface of the first layer of material abuts the first surface of the second layer of material and such that the groove in the first surface of the first layer of material is aligned with the groove in the first surface of the second layer of material; and
the channel is formed by the grooves in the first and second layers of material.
